Europäisches Patentamt

European Patent Office

Office européen des brevets

(11) Publication number: **0 145 583 B1**

# EUROPEAN PATENT SPECIFICATION

(45) Date of publication of patent specification: **27.02.91**  (51) Int. Cl.⁵: **H01L 21/74, H01L 29/52, H01L 29/78**

(21) Application number: **84402454.7**

(22) Date of filing: **30.11.84**

(54) Metal insulator semiconductor device and method for the fabrication thereof.

(30) Priority: **30.11.83 JP 225677/83**

(43) Date of publication of application:
**19.06.85 Bulletin 85/25**

(45) Publication of the grant of the patent:
**27.02.91 Bulletin 91/09**

(84) Designated Contracting States:
**DE FR GB**

(56) References cited:
**EP-A- 0 109 692**
**DE-A- 2 825 433**
**US-A- 4 035 826**

(73) Proprietor: **FUJITSU LIMITED**
**1015, Kamikodanaka Nakahara-ku**
**Kawasaki-shi Kanagawa 211(JP)**

(72) Inventor: **Shirato, Takehide**
**6-26, Sengencho, Hiratsuka-shi**
**Kanagawa 254(JP)**
Inventor: **Yoshida, Toshihiko**
**7-7 Shin-Ishikawa 2 Chome Midori-ku**
**Yokohama-shi Kanagawa 227(JP)**

(74) Representative: **Descourtieux, Philippe et al**
**CABINET BEAU de LOMENIE 55 rue**
**d'Amsterdam**
**F-75008 Paris(FR)**

**Description**

BACKGROUND OF THE INVENTION.

This invention is related to a metal insulator semiconductor type device and its fabricating method, and more particularly to a structure of a MIS device allowing the formation of a contact region for an electrode of the device, and improving the packing density.

In a MIS device, it is important to obtain a good "ohmic contact" at a contact region, in order to attain a high reliability of the semiconductor device. As the scale of integration of the semiconductor device increases, the total size and number of the contact regions increase. The size of the contact region is related directly to the packing density of the semiconductor device. Therefore, it is essential to provide a structure and a fabricating method which allow to decrease the size and number of the contact regions to attain a high integration density.

In a MIS integrated circuit (IC) device, three-terminal field effect transistors (FET) are basically arranged in a common-source, common-drain, or common-gate configuration in order to increase the packing density. In the basic common-source configuration, for example, the source regions of the MIS FETs are connected to a semiconductor substrate region, or well region, on which each MIS FET is fabricated, through a wiring layer, and are kept at the same potential. In many cases, the semiconductor substrate is supplied with a reference voltage

Generally, in a complementary metal oxide semiconductor (CMOS) integrated circuit (IC), substrate contact regions and well contact regions are positioned one by one for each FET. Each of the contact regions is connected to each electrode of the CMOS FET by metal wiring lanes. Such wiring lines for each one of the FETs decrease the integration density of the IC, and disturb its fabrication

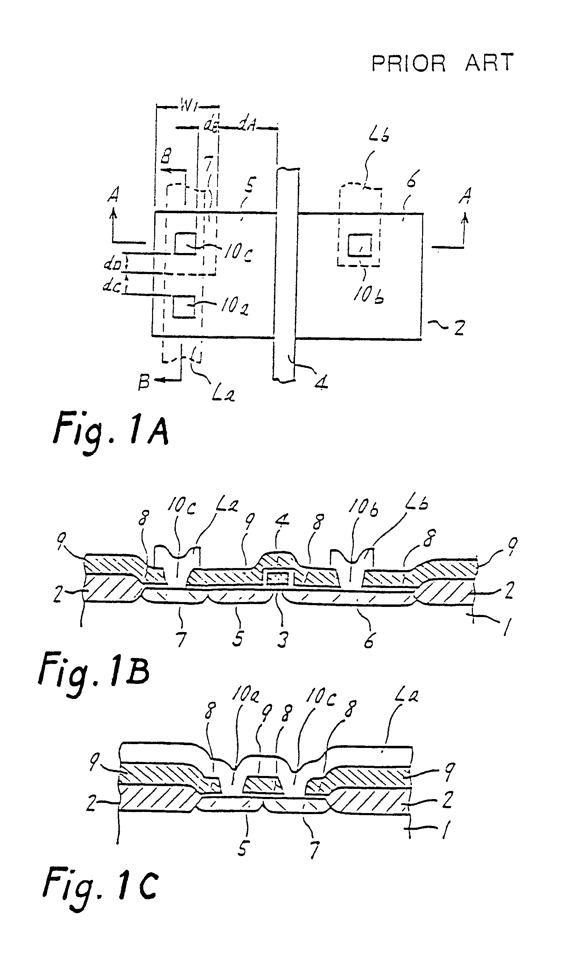

A structure of a MIS FET fabricated in a conventional MIS IC is shown Figures 1A, 1B, 1C where Figure 1A is a plan view of a prior art MIS FET, Figure 1B is a sectional view along the line A-A of Figure 1A and Figure 1C is a sectional view along the line B-B of Figure 1A.

In these figures, 1 is the semiconductor substrate of the MIS FET. A source region 5 of a conductivity type opposite to that of the substrate 1, and a contact diffusion region 7 of the same conductivity type as the substrate 1 are formed on said substrate 1. Contact windows 10a, 10b, 10c for each electrode are formed on insulating layers 8 and 9, the latter being a layer of phosphosilicate glass (PSG).10a is a source electrode contact window corresponding to the source region 5,' 10b is a drain electrode contact window corresponding to the drain region 6, and 10c is a substrate electrode contact window corresponding to the substrate contact region 7. Such electrode contact windows are connected by a wiring layer; the source region 5 is connected to the substrate 1 by a wiring La, the potentials of the source region and the substrate being the same. Reference numeral 2 is a field oxide film, 3 is a gate oxide film, La is a metal wiring line for a reference voltage, and Lb is a metal wiring line supplied with a voltage different from the reference voltage.

According to the prior method for fabricating a HIS FET, it is necessary to provide a certain distance $d_A$ between a gate electrode 4 and an n-type contact region 7 in order to secure a width for the p-type source region 5 and a margin for mask alignment. The width $W$ of the n-type contact region 7 is necessary to assure a proper positioning margin $d_B$ so that the electrode contact window 10c does not protrude from the n-type contact region 7. Moreover, in the direction parallel to the gate electrode 4, electrode contact windows 10a and 10c must be provided with a proper positioning margin $d_C$ and $d_D$ in order to maintain the separation between them.

In the prior art, positioning margins ($d_B$, $d_C$ and $d_D$) for contact diffusion regions are provided by enlarging the size of the contact regions, thereby decreasing the integration density of the MIS IC

U.S. Patent N° 4 035 826 describes a semiconductor device in which low resistance substrate contacts extending through a source region are provided in an integrated circuit employing insulated gate field effect transistors Such low resistance contacts prevent large voltage drops in the substrate underlying the source, thereby preventing "latch-up" of the parasitic devices formed during the manufacture of the integrated circuit However the structure disclosed in that document does not permit an increase in the tolerance for the mask alignment and, moreover, does not lend itself to an increase in the packing density of the device

SUMMARY OF THE INVENTION

It is an object of the present invention to provide a structure of a semiconductor device, more particularly a structure of a MIS IC allowing to increase the packing density of the circuit elements

Another object of the present invention is to provide a method for fabricating this device.

The foregoing objects are accomplished by a semiconductor device including a HIS type circuit element which comprises, according to the invention:

a semiconductor body having one conductivity type, and said MIS type circuit element being fabricated in said semiconductor body;

an electrode region having an opposite conductivity type to that of the body;

a contact region having the same conductivity type as said semiconductor body, said contact region being fabricated by the conversion of a part of said electrode region and having a depth such that it reaches said semiconductor body;

an insulating layer covering said electrode region;

a common contact window opened in said insulating layer and through which the surface of said contact region and a part of said electrode region are exposed; and

a common wiring line formed over the common contact window for connection to said contact region and electrode region;

wherein the contact window has an elongated, generally rectangular shape, spanning across the contact region, parallel to one of the edges of the contact region; the length of the longer edge of the common contact window being longer than the width of the contact region, such that both ends of the common contact window extend beyond the contact region, and the width of the common contact window being smaller than the dimension of the contact region, in the width direction of the common contact window.

Thus, the contact regions for the electrode (source) region and the substrate region are combined to a single contact window. Said single contact window is formed in a part of the electrode (source) region of each FET, by doping with an impurity which has the same conductivity type as the substrate or well region on which the FET is fabricated, said doping being performed at a high dose and deep enough to reach the substrate or well region. Thereafter, the source region is electrically connected directly to the substrate or well region. The positioning margin for each of the contact regions is then reduced and, moreover, the wiring for connecting them is eliminated. The packing density of the device is therefore increased.

These and other features and advantages of the device and method according to the invention will become apparent from the following detailed description made in connection with the accompanying drawings.

## BRIEF DESCRIPTION OF THE DRAWINGS

Figure 1A is a schematic plan view of a pattern layout of a prior art semiconductor device.

Figure 1B is a schematic cross-sectional view taken along the line A-A in the Figure 1A.

Figure 1C is a schematic cross-sectional view taken along the line B-B in the Figure 1A.

Figure 2A is a schematic plan view of a pattern layout of a p-channel MOS FET according to a first embodiment of the present invention.

Figure 2B is a schematic cross-sectional view taken along the line A-A in the Figure 2A.

Figure 2C is a schematic cross-sectional view taken along the line B-B in the Figure 2A.

Figure 3A is a schematic plan view of a pattern layout of a CMOS FET according to a second embodiment of the present invention.

Figure 3B is a schematic cross-sectional view taken along the line A-A in the Figure 3A.

Figure 3C is a schematic cross-sectional view taken along the line B-B in the Figure 3A.

Figure 3D is a schematic cross-sectional view taken along the line C-C in the Figure 3A.

Figures 4A to 4F illustrate schematically different steps of the fabrication method for a semiconductor device according to the present invention.

Figure 5 is a schematic plan view of a resist pattern with an opening window of a contact region which provides margin for alignment.

Figures 6A and 6B are schematic plan views of an opening of contact region for a source electrode which provides margin for alignment.

Same or like reference numerals denote the same or like parts throughout the drawings

## DESCRIPTION OF THE PREFERRED EMBODIMENTS

Compared to the prior art structure of Figures 1A, 1B and 1C, the present invention intends to combine the contact regions for the electrode (source) region and substrate region to a single hole, and intends to secure a margin space aligning without need for a special margin space

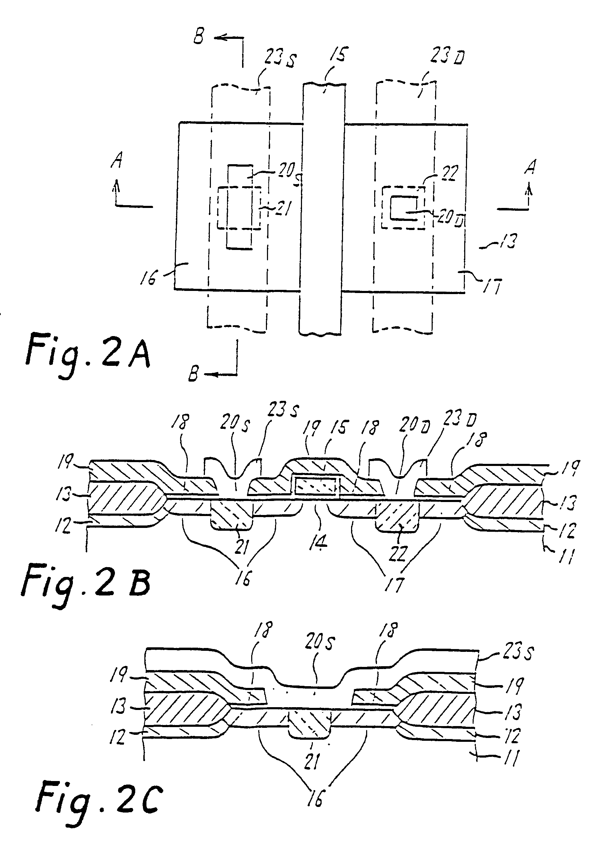

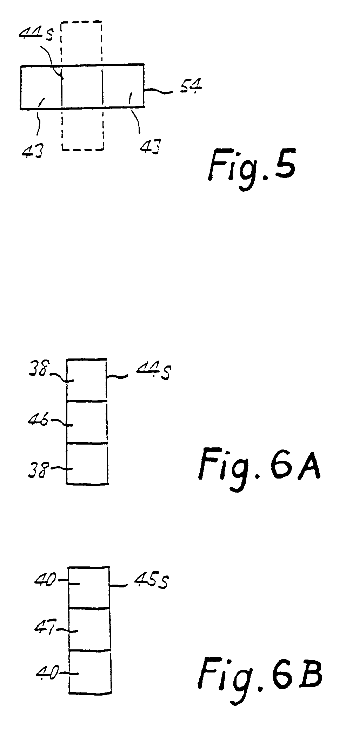

Figures 2A, 2B and 2C show a p-channel MOS FET (p-MOS) according to the present invention. A contact window 20s for a $p^+$-type source 16, hereinafter common contact window, is formed with a rectangular shape. Through the center part of this window 20s, an n-type impurity is selectively doped at a high dose into the $p^+$ source region 16 and the center part of the $p^+$-type source region 16 is converted to an $n^+$-type conductivity region 21 As shown in the figure the high dose region 21 becomes wider than the window 20s, because of the diffusion. The detail of such diffusion will be disclosed later with respect to Figure 5. The $n^+$-type substrate contact diffusion region 21 is deep enough to reach the n-type substrate 11, so that $n^+$-type contact region 21 is formed in the center part of the contact window 20s.

When a common wiring line 23s is fabricated on insulating layers of phospho-silicate glass (PSG) 19, as shown in the figures, the $p^+$-type source region 16 and $n^+$-type contact region 21 are connected to each other (Figure 2C). As a result, the $p^+$-type source region 16 is electrically connected to the contact region 21 which is electrically connected to n⁻-type silicon substrate 11. Therefore, the above regions are at the same potential despite the presence of a p-n junction between them, and they are connected to a common wiring line 23s.

A diffusion region 22, which is a $p^{++}$-type region compensated by impurity, is formed at a part of a drain region 17 by diffusion through an opening 20$_D$. Compensated diffusion is a conventional technique widely used to prevent a contact region from a short of p-n junction. In particular, the compensated diffusion technique is useful to obtain good "ohmic contact" at the contact region, in order to attain high reliability of the semiconductor device.

An impurity region of an element of a semiconductor device is usually formed by diffusing an impurity material (dopant) into a specified region of the substrate, which region is hereafter called "diffusion region".

In Figures 2A, 2B and 2C, 12, 13 and 14 are respectively a n⁻-type channel cut region, a field oxide film, and a gate oxide film, and 15 is a polycrystalline silicon gate electrode. These are all widely used in conventional MOS device and their description is omitted for sake of simplicity.

As described above, the contact windows for the source region 16 and substrate region 21 are combined to one common opening contact window 20s. Compared to the prior construction of the figure 1, the wiring line from the source region to the substrate region is omitted, and the positioning margin required for positioning each contact window with respect to each region 16 or 21 becomes unnecessary. Therefore, the scale of integration of the semiconductor device is increased.

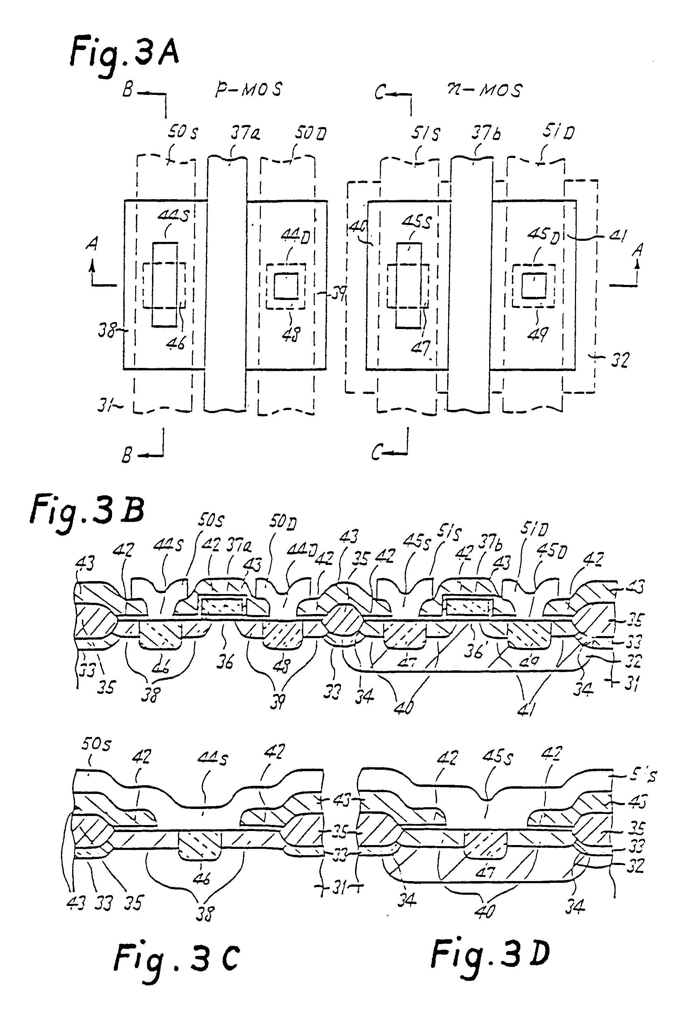

Figure 3A is a schematic plan view of a pattern layout of CMOS FET according to a second embodiment of the present invention, which includes a complementary metal oxide semiconductor (CMOS) structure. Figure 3B, 3C and 3D being schematic cross-sectional views respectively taken along the lines A-A, B-B and C-C of Figure 3A.

Reference numeral 31 denotes an n⁻-type silicon substrate, 32 is a p-type well region, 33 is an n⁻-channel cut region, 34 is a $p^-$-channel cut region, 35 is a field oxide film, 36 is a gate oxide film, 37a and 37b are polycrystalline silicon gate electrodes, 38 is a $p^-$-type source region, 39 is a $p^-$-type drain region, 40 is an $n^-$-type source region, 41 is an $n^-$-type drain region, 42 is an oxide film for impurity material blockade, 43 is an insulating layer of phospho-silicate glass (PSG) 44$_D$ and 45$_D$ are electrode contact windows for drain regions, 46 is a contact region for $n^+$-type substrate, 47 is a contact region for $p^+$-type well, 48 is a $p^{++}$-type compensation diffusion region, 49 is an $n^{++}$-type compensation diffusion region, 50$_D$ is a drain wiring layer of a p-MOS and 51$_D$ is a drain wiring layer of an n-MOS. The substrate region 31 and well region 32 of elements of a semiconductor device are usually formed by diffusing impurity material (dopant) to a specified region in a substrate, which will be called hereinafter "semiconductor body".

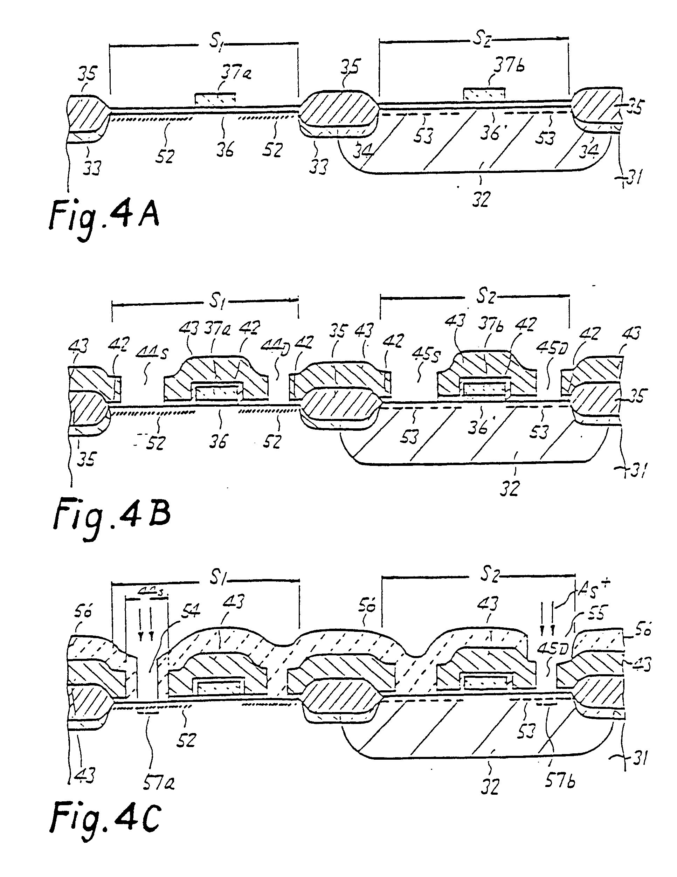

The fabrication process will be described later referring to Figures 4A to 4F.

In the p-MOS of the CMOS FET, as shown in Figure 3A to 3D, a rectangular electrode contact window 44s is formed on the source region 38. An n-type impurity material of high concentration is selectively doped into a center part of the contact window 44s, which produces a conversion region and an n⁻-type substrate contact region 46 is selectively formed, reaching into the region of the n⁻-type silicon substrate 31. The selective doping is performed in a manner similar to the one described with respect to Figures 2A to 2C. The detail of this selective doping will be described later with respect to Figure 5.

Similarly, in the n-MOS of the CMOS FET a rectangular common contact window 45s is formed in the source region 40. A p-type impurity material of high concentration is selectively doped into a part of the n⁻-type source region 40. As a result, a conversion region is produced and a $p^-$-type well contact diffusion region 47 is selectively formed which reaches into the region of the p-type well region 32.

As shown in Figures 3A to 3D, the $p^-$-type source region 38 is connected to the n⁻-type substrate contact region 46 which is electrically connected to the n⁻-type silicon substrate 31. Said regions are then held at the same potential by means of a common wiring line 50s despite the presence of p-n junction between them.

Similarly, the $n^-$-type source region 40 is connected to the $p^-$-type well contact region 47 which is electrically connected to the p-type well region 32. As a result, said regions are held at the same potential by the common wiring line 51s.

Therefore, the contact windows for source region and substrate region are combined into a common single window. Compared to the prior construction of figures 1A to 1C, the wiring line from the source region to the substrate region is omitted, and the margin required for contact windows can be neglected; the scale of integration of the semiconductor device being therefore increased.

A process for fabricating a device according to the present invention will now be disclosed with reference to Figures 4A to 4F which illustrate schematically different steps of the fabrication process. The elementary processing methods used such as etching, insulating layer formation, aluminum sputtering, lithographic technology etc. are conventional ones being well known in the art. Therefore, detailed descriptions regarding these technologies are omitted in the following disclosure.

In Figure 4A, reference numeral 33 is the $n^+$-channel cut region, 34 is the $p^+$-channel cut region and 35 is the field oxide film. They are formed by using a well known and widely used technology in the art. By a conventional processing such as thermal oxidation, a gate oxide film 36 is formed on the silicon substrate 31 at the p-MOS FET region $S_1$. Similarly, at the same time, the gate oxide film 36 is formed on the p-type well region 32 which will become the n-MOS FET region $S_2$. The polycrystalline silicon gate electrodes 37a and 37b are formed on the gate oxide film 36. They are fabricated by a conventional method such as chemical vapor deposition (CVD) and patterned by a photolithography. Using the gate electrode 37a or 37b as a mask, boron (B), a dopant material, is selectively ion-implanted into the n-type silicon substrate 31 through the gate oxide layer 36. Similarly, arsenic (As), a dopant material, is selectively ion-implanted into the p-type well region 32. The doping densities of boron and arsenic are both in the region 32. The doping density of boron and arsenic are both in the range of approximately $1 \times 10^{15}$ (atm cm$^2$) to $4 \times 10^{15}$ (atm cm$^2$). As a result, a first boron (B) doped region 52 and a first arsenic (As) doped region 53 are formed.

Figure 48 illustrates a method for fabrication of the common contact windows 44s and 45s, and of the drain electrode contact windows $44_D$ and $45_D$.

Using conventional photolithographic technology, as shown in the Figure 4B, the gate oxide film 36 is removed, and the thin oxide layer 42 is formed again all over the substrate by a conventional thermal oxidizing method. This oxide layer 42 is used to block the impurity materials. Then, the phospho-silicate glass (PSG) insulating layer 43 is formed over the entire substrate. The common contact windows 44s and 45s, at the sources of the p-MOS FET and the n-MOS FET respectively, and the drain electrode contact windows $44_D$ and $45_D$ are then formed above the first doped region 52. In order to promote a better understanding, the layout of the common contact windows 44s end 45s is shown in the figures hereinafter described, 90° rotated from their original orientation as shown in the cross sectional views of Figures 3C and 3D.

Figure 4C illustrates a method of formation of phosphorus (P) doped region 57a or 57b. A first resist pattern 56 is formed on the substrate, and patterned to have openings 54 and 55 in the areas of windows 44s and $45_D$. The opening 54 is narrower than the opening 44s, and the opening 55 is wider than the opening $45_D$. The difference of size between these openings is effective for mask alignment as will be described later with respect to Figure 5. By using the resist pattern 56 and the insulator film 43 as a mask, phosphorus(P) is selectively ion-implanted into the n -type silicon substrate 31 through the openings 54 and 44s and into the p-type well 32 through the openings 55 and $45_D$. The doping density is in the range of approximately $5 \times 10^{15}$ to $1 \times 10^{16}$ atm/cm$^2$ and the acceleration voltage is of 70 to 180 keV.

As a result, the phosphoros (P) doped region 57a is formed, having a deeper doped region compared to the boron doped region 52 with the second doped region 57a as well as portions of the first doped region 52 adjoining it being exposed through the rectangular common contact window 44s. Simultaneously the phosphoros (P) doped region 57b is formed, having a deeper doped region compared to the arsenic (As) doped region 53.

Figure 5 is a schematic plan view showing the relation between the opening 54 on the first resist pattern 56 and the opening 44s on the PSG layer 43. Since the rectangles defined by these openings are arranged orthogonally to each other, the opening towards substrate 31 is formed at the cross zone of the openings 54 and 44s. As can be seen in the figure, each of the openings 54 and 44s has a length which exceeds the tolerance of mask, and the alignment is therefore quite easy. The opening 55 for the drain opening $45_D$ also provides enough margin for mask alignment.

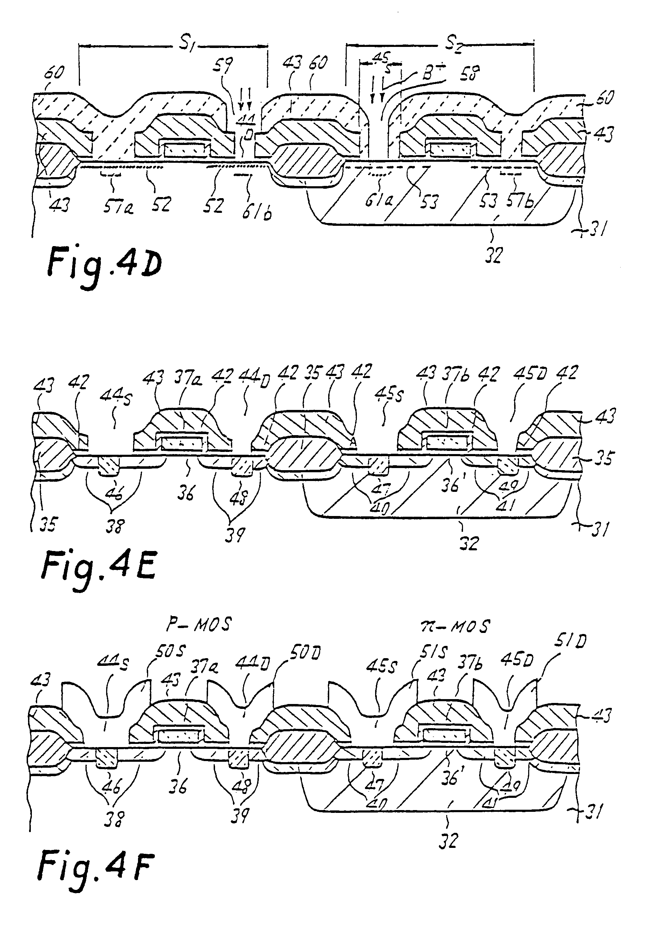

Turning back to figure 4D, the formation of boron doped region 61a or 61b will now be described. The first resist pattern 56 is removed and a second resist pattern 60 is formed on the substrate and patterned to have openings 58 and 59 in the areas of windows $44_D$ and 45s. The opening $44_D$ is narrower than the opening 59, and the opening 45s is wider than the opening 58. The difference of size between these openings is effective for the mask alignment in a similar manner as described with respect to Figure 5. By using the resist mask 60 as a mask, boron (B) is selectivley ion-implanted in the p-type well region 32. The doping density is in the range of approximately $5 \times 10^{15}$ to $1 \times 10^{16}$ atm cm$^2$ and the acceleration voltage is of 70 to 180 kev.

As a result, the second B doped region 61a is formed, being a deeper doped region compared to the first arsenic (As) doped region 53. Simultaneously, the second boron (B) doped region 61b is formed, being a relatively deeper diffusion region compared to the first boron (B) doped region 52. That is, the second dopant has a higher concentration than the first, and the second doped region reaches deeper than the first doped region into the substrate 31 or well region 32.

Figure 4E relates to an activation process. The second resist pattern 60 is removed from the substrate and annealing is performed at a temperature of about 950°C for 30 minutes in order to activate the doped impurity materials (dopant). The doped impurity materials diffuse in the different regions. The $p^+$-type source region 38, the $p^+$-type drain region 39, the $n^+$-type source region 40, the $n^+$-type drain region 41, the $n^+$-type substrate contact diffusion region 46, the $p^+$-type well contact diffusion region 47, the $p^{++}$-type compensate diffusion region 48 and the $n^{++}$-type compensate diffusion region 49 are formed as shown in Figure 4E.

During the activation step of Figure 4E, both the surfaces of the $n^+$-type substrate contact diffusion region 46 and of the $p^+$-type source region 38 are exposed through the common contact windows 44s as shown in Figure 6A. The surface of the $p^{++}$type compensate diffusion region 48 is exposed through the drain electrode contact window $44_D$. Both the surfaces of the $p^+$-type well contact diffusion region 47 and of the $n^+$-type source region 40 are exposed through the common contact window 45s of the n-MOS FET as shown in Figure 6B. The $n^{++}$-type compensate diffusion region 49 is exposed through the drain electrode contact window $45_D$. Figures 6A and 6B are orientated in the same direction as Figure 3A.

Figure 4F relates to the step of fabrication of wiring. Conventional sputtering and lithographic processes are used. The common wiring 50s of p-MOS FET is formed covering the common contact window 44s and connecting both the surfaces of the $n^+$-type substrate contact region 46 and $p^+$-type source region 38. Generally, an aluminum(Al)-film is used as wiring material. Similarly, the drain wiring $50_D$ of p-MOS FET is formed for connection to the surface of the $p^{++}$-type compensate diffusion region 48 through the contact window $44_D$ for drain electrode. The common wiring 51s of n-MOS FET is formed over the common contact window 45s connecting the $p^+$-type source region 47 and $n^+$-type source region 40. The drain wiring $51_D$ for n-MOS FET is formed for connection to the $n^{++}$-type compensate diffusion region 49 through the electrode contact window $45_D$. Finally, the entire surface of the substrate is coated with an insulating layer. As described above, the CMOS FET can be formed without additional fabrication process for the IC.

According to the present invention, for example, the marginal distance $(d_A + d_B)$ for the gate electrode and the common contact window can be reduced by 2 μm from that of 4 μm of the prior art. In addition, a marginal distance $(d_C + d_D)$ for the electrode contact window of the source region and the electrode contact window for the substrate is unnecessary. With contact windows (38 and 40 as shown in Figures 6A and 6B) advantageously enlarged by 2 μm in the device of the present invention, a total reduction of marginal distance of 2 μm is obtained. This reduction in marginal space is very large compared to the size of FETs. For example, the size of a FET used in a LSI is approximately 11 μm x 8 μm. Therefore, it will be understood that the reduction of 2 μm has a large influence on the packing density of the device, which means that the size of an elementary device is decreased by approximately 20% in surface and it will be clearly understood that due to such small sized elements, the packing density of IC can be increased to a greater extent.

In the above disclosure ion-implantation has been used for the doping with impurities, but it can be replaced by any other known process, such as diffusion.

## Claims

1. A semiconductor device including a MIS type circuit element, said MIS type circuit element having:

a semiconductor body (11 ; 31 , 32) having one conductivity type, and said MIS type circuit element being fabricated in said semiconductor body.

an electrode region (16 ; 38 ; 40) having an opposite conductivity type to that of the body ;

a contact region (21 ; 46 , 47) having the same conductivity type as said semiconductor body, said contact region being fabricated by the conversion of a part of said electrode region and having a depth such that it reaches said semiconductor body ;

an insulating layer (19 ; 43) covering said electrode region ;

a common contact window (20s ; 44s , 45s) opened in said insulating layer and through which the surface of said contact region and a part of said electrode region are exposed ; and

a common wiring line (23s ; 50s ; 51s) formed over the common contact window for connection to said contact region and electrode region; characterized in that: said common contact window (20s ; 44s ; 45s) has an elongated, generally rectangular shape, spanning across said contact region (21 ; 46 ; 47), parallel to one of the edges of the contact region ; the length of the longer edge of said common contact window being longer than the width of said contact region, such that both ends of said common contact window extend beyond said contact region ; and

the width of the common contact window is smaller than the dimension of the contact region, in the width direction of the common contact window.

2. A semiconductor device according to claim 1, characterized in that said semiconductor body is a substrate (11 ; 31).

3. A semiconductor device according to claim 1, characterized in that said semiconductor body is a well region (32) formed in a semiconductor substrate (31).

4. A semiconductor device according to claim 1, characterized in that said MIS type circuit element is a MIS transistor, and said electrode region is a source region (16) of the MIS transistor.

5. A semiconductor device according to claim 1, characterized in that said MIS type circuit element constitutes complementary MIS transistors.

6. A method for fabricating a semiconductor device including a MIS type circuit element, characterized by the steps of :

a) forming a first doped region on the surface of a semiconductor body (11; 31), said first doped region (16; 38; 40; 52) having a conductivity type opposite to that of said semiconductor body;

b) forming an insulator film (19 ; 43) on the surface of the body ;

c) forming a common contact window (20s ; 44s ; 45s) on said insulator film above said first doped region, said common contact window having an elongated rectangular form arranged in parallel to the gate electrode (15 ; 37a ; 37b) of the MIS type circuit element ;

d) covering the substrate with a first resist film (56) and patterning the first resist film to form a first opening (54) on it, said first opening having a rectangular shape, and being arranged above said common contact window and orthogonally with respect to the rectangle defined by said common contact window ;

e) forming a second doped region (21 ; 46 ; 47 ; 57a) on the surface of said semiconductor body using the patterned resist film and the insulator film as a mask ; said second doped region having a same conductivity type as that of said semiconductor body, and the depth of the second doped region being deeper than the depth of the first doped region and reaching said semiconductor body, said second doped region as well as portions of the first doped region adjoining it being exposed through said rectangular common contact window;

f) removing said first resist film;

g) forming a wiring layer (50s) covering the common contact window.

7. A method for fabricating a semiconductor device according to claim 6, characterized in that steps a) and e) are carried out by ion-implantation and the dose rate of the ion-implantation for step e) is larger than that for step a).

8. A method for fabricating a semiconductor device according to claim 6, characterized in that said semiconductor body is a silicon substrate and the insulator film formed in the step b) is a phospho-silicate glass film.

9. A method for fabricating a semiconductor device according to claim 8, characterized in that: said semiconductor body comprises a substrate (11,13) wherein a well region (32) is formed such that said substrate (11 . 31) is made of n-type silicon and said well region (32) is made of p-type silicon ; the first dopant used in the step a) is boron (B) . and the second dopant used in the step e) is phosphorus (P).

10. A method for fabricating a semiconductor device according to claim 8, characterized in that : said semiconductor body comprises a substrate wherein a well region (32) is formed such that said substrate (11 ; 31) is made of n-type silicon and said well region (32) is made of p-type silicon ; the first dopant used in the step a) is arsenic (As) ; and the second dopant used in the step e) is boron (B).

11. A method for fabricating a semiconductor device according to claim 8, characterized in that said steps a) and e) are respectively performed by an ion-implantation and subsequent annealing process.

12. A method for fabricating a semiconductor device according to claim 9, characterized in that : the acceleration voltage of the dopant for the steps a) and e) is in the range of 70 to 180 keV ; and the annealing is effected for about 30 minutes at a temperature of approximately 950°C.

## Revendications

1. Dispositif semiconducteur comportant un élément de circuit du type MIS, ledit élément de circuit du type MIS possédant :

un corps semiconducteur (11 ; 31 ; 32) ayant un premier type de conductivité, ledit élément de circuit de type MIS étant fabriqué dans ledit corps semiconducteur ;

une région d'électrode (16 ; 38 ; 40) ayant un type de conductivité opposé à celui du corps ;

une région de contact (21 ; 46 ; 47) ayant le même type de conductivité que ledit corps semiconducteur, ladite région de contact étant fabriquée par transformation d'une partie de ladite région d'électrode et ayant une profondeur telle qu'elle atteint ledit corps semiconducteur ;

une couche isolante (19 ; 43) couvrant ladite région d'électrode ;

une fenêtre de contact commune (20s ; 44s ; 45s) ouverte dans ladite couche isolante et dans laquelle la surface de ladite région de contact et une partie de ladite région d'électrode sont exposées ; et

une ligne de câblage commune (23s ; 50s ; 51s) formée au-dessus de la fenêtre de contact commune pour établir une connexion avec ladite région de contact et ladite région d'électrode ; caractérisé en ce que :

ladite fenêtre de contact commune (20s ; 44s ; 45s) possède une forme allongée sensiblement rectangulaire, qui s'étend sur ladite région de contact (21 ; 46 ; 47) parallèlement à un des bords de la région de contact ; la longueur du bord le plus long de ladite fenêtre de contact commune étant plus grande que la largeur de ladite région de contact, de sorte que les deux extrémités de ladite fenêtre de contact commune s'étendent au-delà de ladite région de contact ; et

la largeur de la fenêtre de contact commune est plus petite que la dimension de la région de contact, suivant la direction de la largeur de la fenêtre de contact commune.

2. Dispositif semiconducteur selon la revendication 1, caractérisé en ce que ledit corps semiconducteur est un substrat (11 ; 31).

3. Dispositif semiconducteur selon la revendication 1, caractérisé en ce que ledit corps semiconducteur est une région de puits (32) formée dans un substrat semiconducteur (31).

4. Dispositif semiconducteur selon la revendication 1, caractérisé en ce que ledit élément de circuit de type MIS est un transistor MIS, et ladite région d'électrode est une région de source (16) du transistor MIS.

5. Dispositif semiconducteur selon la revendication 1, caractérisé en ce que ledit élément de circuit de type MIS constitue des transistors MIS complémentaires.

6. Procédé de fabrication d'un dispositif semiconducteur comportant un élément de circuit de type MIS, caractérisé par les opérations suivantes :

a) former une première région dopée sur la surface d'un corps semiconducteur (11 ; 31), ladite première région dopée (16 ; 38 ; 40 ; 52) ayant un type de conductivité opposé à celui dudit corps semiconducteur ;

b) former une pellicule isolante (19 ; 43) à la surface du corps ;

c) former une fenêtre de contact commune (20s ; 44s ; 45s) sur ladite pellicule isolante au-dessus de ladite première région dopée, ladite fenêtre de contact commune ayant une forme allongée rectangulaire disposée parallèlement à l'électrode de grille (15 ; 37a ; 37b) de l'élément de circuit du type MIS ;

d) recouvrir le substrat à l'aide d'une première pellicule d'agent sensible du type réserve (56) et configurer la première pellicule d'agent sensible afin de former une première ouverture (54) sur celle-ci, ladite première ouverture ayant une forme rectangulaire, et étant disposée au-dessus de ladite fenêtre de contact commune perpendiculairement par rapport au rectangle défini par ladite fenêtre de contact commune ;

e) former une deuxième région dopée (21 ; 46 ; 47 ; 57a) à la surface dudit corps semiconducteur en utilisant la pellicule d'agent sensible configurée et la pellicule isolante comme masque ; ladite deuxième région dopées ayant le même type de conductivité que ledit corps semiconducteur, et la profondeur de la deuxième région dopée étant plus grande que la profondeur de la première région dopée et atteignant ledit corps semiconducteur, ladite deuxième région dopée ainsi que des parties de la première région dopée adjacentes à celle-ci étant exposées via ladite fenêtre de contact commune rectangulaire ;

f) retirer ladite première pellicule d'agent sensible ;

g) former une couche de câblage (50s) recouvrant la fenêtre de contact commune.

7. Procédé de fabrication d'un dispositif semiconducteur selon la revendication 6, caractérisé en ce que les opérations a) et e) sont effectuées par implantation ionique et en ce que la dose de l'implantation ionique relative à l'opération e) est plus grande que celle relative à l'opération a).

8. Procédé de fabrication d'un dispositif semiconducteur selon la revendication 6, caractérisé en ce que ledit corps semiconducteur est un substrat de silicium et la pellicule isolante formée à l'opération b) est une pellicule de verre de phosphosilicate.

9. Procédé de fabrication d'un dispositif semiconducteur selon la revendication 8, caractérisé en ce que :

ledit corps semiconducteur comprend un substrat (11, 31), où une région de puits (32) est formée de façon que ledit substrat (11 ; 31) soit fait de silicium de type n et ladite région de puits (32) soit faite de silicium de type p ;

le premier agent dopant utilisé à l'opération a) est le bore (B) ; et

le deuxième agent dopant utilisé à l'opération e) est le phosphore (P).

10. Procédé de fabrication d'un dispositif semiconducteur selon la revendication 8, caractérisé en ce que :

ledit corps semiconducteur comprend un substrat (11, 31) où une région de puits (32) est formée de façon que ledit substrat (11 ; 31) soit fait de silicium de type n et ladite région de puits (32) soit faite de silicium de type p :

le premier agent dopant utilisé à l'opération a) est l'arsenic (As) ; et

le deuxième agent dopant utilisé à l'opération e) est le bore (B).

11. Procédé de fabrication d'un dispositif semiconducteur selon la revendication 8, caractérisé en ce que les opérations a) et e) sont respectivement réalisées par une implantation ionique suivie d'un traitement de recuit.

12. Procédé de fabrication d'un dispositif semiconducteur selon la revendication 9, caractérisé en ce que :

la tension d'accélération de l'agent de dopage relatif aux opérations a) et e) est comprise entre 70 et 180 (keV) ; et

le recuit est effectué pendant environ 30 min à une température d'environ 950° C

**Ansprüche**

1. Halbleitervorrichtung mit einem MIS-Typ-Schaltungselement, welches genannte MIS-Typ-Schaltungselement hat:

einen Halbleiterkörper (11; 31; 32), der einen Leitfähigkeitstyp hat, und welches MIS-Typ-Schaltungselement in dem genannten Halbleiterkörper hergestellt ist;

einen Elektrodenbereich (16; 38; 40), der einen Leitfähigkeitstyp hat, der zu jenem des Körpers entgegengesetzt ist;

einen Kontaktbereich (21; 46; 47), der denselben Leitfähigkeitstyp wie der Halbleiterkörper hat, welcher Kontaktbereich durch Konversion eines Teils des genannten Elektrodenbereichs hergestellt ist und eine solche Tiefe hat, daß er den genannten Halbleiterkörper erreicht;

eine isolierende Schicht (19; 43), die den genannten Elektrodenbereich bedeckt;

ein gemeinsames Kontaktfenster (20s; 44s; 45s), das in der genannten isolierenden Schicht geöffnet ist und durch welches die Oberfläche des genannten Kontaktbereichs und ein Teil des genannten Elektrodenbereichs exponiert sind; und

eine gemeinsame Verdrahtungsleitung (23s; 50s; 51s), die über dem gemeinsamen Kontaktfenster gebildet ist, um den genannten Kontaktbereich und den Elektrodenbereich zu verbinden; dadurch gekennzeichnet, daß

das gemeinsame Kontaktfenster (20s; 44s; 45s) eine längliche, im allgemeinen rechtwinklige Form hat, welche sich quer über den genannten Kontaktbereich (21; 46; 47) spannt, parallel zu einem der Ränder des Kontaktbereichs; die Länge des längeren Randes des genannten gemeinsamen Kontaktfensters länger als die Breite des genannten Kontaktbereichs ist, so daß beide Enden des gemeinsamen Kontaktfensters sich jenseits des genannten Kontaktbereichs erstrecken; und

die Breite des gemeinsamen Kontaktfensters in der Breitenrichtung des gemeinsamen Kontaktfensters kleiner als die Dimension des Kontaktbereichs ist.

2. Halbleitervorrichtung nach Anspruch 1, dadurch gekennzeichnet, daß der genannte Halbleiterkörper ein Substrat (11; 31) ist.

3. Halbleitervorrichtung nach Anspruch 1, dadurch gekennzeichnet, daß der genannte Halbleiterkörper ein Grabenbereich (32) ist, der in dem genannten Halbleitersubstrat (31) gebildet ist.

4. Halbleitervorrichtung nach Anspruch 1, dadurch gekennzeichnet, daß das genannte MIS-Typ-Schaltungselement ein MIS-Transistor ist, und der genannte Elektrodenbereich ein Sourcebereich (16) des MIS-Transistors ist.

5. Halbleitervorrichtung nach Anspruch 1, dadurch gekennzeichnet, daß das genannte MIS-Typ-Schaltungselement komplementäre MIS-Transistoren bildet.

6. Verfahren zur Herstellung einer Halbleitervorrichtung mit einem MIS-Typ-Schaltungselement, gekennzeichnet durch die folgenden Schritte:

a) Bilden eines ersten dotierten Bereichs auf der Oberfläche eines Halbleiterkörpers (11; 31), welcher erste dotierte Bereich (16; 38; 40; 52) einen Leitfähigkeitstyp entgegengesetzt zu jenem des genannten Halbleiterkörpers hat;

b) Bilden eines Isolatorfilms (19; 43) auf der Oberfläche des Körpers;

c) Bilden eines gemeinsamen Kontaktfensters (20s; 44s; 45s) auf dem genannten Isolatorfilm oberhalb des genannten ersten dotierten Bereichs, welches genannte gemeinsame Kontaktfenster eine längliche rechtwinklige Form hat, die parallel zu den Gateelektroden (15; 37a; 37b) des MIS-Typ-Schaltungselements angeordnet ist;

d) Bedecken des Substrats mit einem ersten Resistfilm (56) und Mustern des ersten Resistfilms, um eine erste Öffnung (54) auf ihm zu bilden, welche erste Öffnung eine rechtwinklige Form hat und oberhalb des gemeinsamen Kontaktfensters und rechtwinklig in Bezug auf das Rechteck angeordnet ist, das durch das gemeinsame Kontaktfenster definiert ist;

e) Bilden eines zweiten dotierten Bereichs (21; 46; 47; 57a) auf der Oberfläche des genannten Halbleiterkörpers, unter Verwendung des gemusterten Resistfilms und des Isolatorfilms als eine Maske; welcher zweite dotierte Bereich einen selben Leitfähigkeitstyp wie jener des genannten Halbleiterkörpers hat, und wobei die Tiefe des zweiten dotierten Bereichs tiefer als die Tiefe des ersten dotierten Bereichs ist und den genannten Halbleiterkörper erreicht, welcher zweite dotierte Bereich so wie Abschnitte des ersten dotierten Bereichs, die an ihn angrenzen, durch das genannte rechtwinklige gemeinsame Kontaktfenster dotiert ist;

f) Entfernen des genannten ersten Resistfilms;

g) Bilden einer Verdrahtungsschicht (50s), die das gemeinsame Kontaktfenster bedeckt.

7. Verfahren zur Herstellung einer Halbleitervorrichtung nach Anspruch 6, dadurch gekennzeichnet, daß die Schritte a) und e) durch Ionenimplantation durchgeführt werden und die Dosierungsrate der Ionenimplantation für den Schritt e) größer als für den Schritt a) ist.

8. Verfahren zur Herstellung einer Halbleitervorrichtung nach Anspruch 6, dadurch gekennzeichnet, daß der genannte Halbleiterkörper ein Siliciumsubstrat ist, und der bei dem Schritt b) gebildete Isolatorfilm ein Phosphosilikatglasfilm ist.

9. Verfahren zur Herstellung einer Halbleitervorrichtung nach Anspruch 8, dadurch gekennzeichnet, daß der genannte Halbleiterkörper ein Substrat (11; 31) umfaßt, in dem ein Grabenbereich (32) so gebildet ist, daß das genannte Substrat (11; 31) aus n-Typ-Silicium gebildet ist und der genannte Grabenbereich (32) aus p-Typ-Silicium gebildet ist;

das erste Dotierungsmittel, das bei dem Schritt a) verwendet wird, Bor (B) ist; und

das zweite Dotierungsmittel, das bei dem Schritt e) gebildet wird, Phosphor (P) ist

10. Verfahren zur Herstellung einer Halbleitervorrichtung nach Anspruch 8, dadurch gekennzeichnet, daß:

der genannte Halbleiterkörper ein Substrat (11, 31) umfaßt, in dem ein Grabenbereich (32) so geformt ist, daß das genannte Substrat (11 31) aus n-Typ-Silicium gebildet ist und der genannte Grabenbereich (32) aus p-Typ-Silicium gebildet ist;

das erste Dotierungsmittel, das bei dem Schritt a) verwendet wird, Arsen (As) ist; und

das zweite Dotierungsmittel, das bei dem Schritt e) verwendet wird, Bor (B) ist.

11. Verfahren zur Herstellung einer Halbleitervorrichtung nach Anspruch 8, dadurch gekennzeichnet, daß die genannten Schritte a) und e) jeweils durch Ionenimplantation und durch einen folgenden Anneal-Prozeß durchgeführt werden.

12. Verfahren zur Herstellung einer Halbleitervorrichtung nach Anspruch 9, dadurch gekennzeichnet, daß:

die Beschleunigungsspannung des Dotierungsmittels für die Schritte a) und e) im Bereich von 70 bis 180 keV liegt; und

der Anneal-Prozeß etwa 30 Minuten lang bei einer Temperatur von ungefähr 950°C durchgeführt wird.

PRIOR ART

Fig. 1A

Fig. 1B

Fig. 1C

Fig. 2A

Fig. 2 B

Fig. 2C

EP 0 145 583 B1

*Fig.3A*

*Fig.3B*

*Fig.3C*

*Fig.3D*

14

Fig.4 A

Fig.4 B

Fig.4 C

Fig.4D

Fig.4E

Fig.4F

44 s

43    43

54

## Fig.5

38    44 s

46

38

## Fig. 6 A

40    45 s

47

40

## Fig. 6 B